Europäisches Patentamt

European Patent Office

Office européen des brevets

(11) Publication number: **0 029 679**
**B1**

(12) **EUROPEAN PATENT SPECIFICATION**

(45) Date of publication of patent specification: **20.03.85**

(51) Int. Cl.⁴: **H 01 L 31/08, H 01 L 27/14**

(21) Application number: **80304022.9**

(22) Date of filing: **11.11.80**

(54) **Photoelectric device.**

(30) Priority: **14.11.79 JP 146579/79**

(43) Date of publication of application:
**03.06.81 Bulletin 81/22**

(45) Publication of the grant of the patent:
**20.03.85 Bulletin 85/12**

(84) Designated Contracting States:
**DE FR GB NL**

(56) References cited:
**EP-A-0 033 230**
**FR-A-2 366 698**
**GB-A-2 014 783**
**GB-A-2 037 077**

**APPLIED PHYSICS LETTERS, vol. 35, no. 4, August 15, 1979, Am. Inst. of Phys. NEW YORK (US) Y. IMAMURA et al.: "Photoconductive imaging using hydrogenated amorphous silicon film" pages 349-351**

(73) Proprietor: **Hitachi, Ltd.**
**5-1, Marunouchi 1-chome**
**Chiyoda-ku Tokyo 100 (JP)**

(72) Inventor: **Takasaki, Yukio**
**1-47-1-D401 Akatsuki-cho**
**Hachioji-shi Tokyo (JP)**
Inventor: **Hirai, Tadaaki**
**1-6-12 Sakura-cho**
**Koganei-shi Tokyo (JP)**
Inventor: **Yamamoto, Hideaki**
**3-21-A404 Koyasu-cho**
**Hachioji-shi Tokyo (JP)**
Inventor: **Tsukada, Toshihisa**
**4-kou704-17-B405 Sekimachi**
**Nerima-ku, Tokyo (JP)**
Inventor: **Mori, Yoshiaki**
**2-19-7 Fujimidaira Hamuramachi**
**Nishitamagun Tokyo (JP)**

(74) Representative: **Paget, Hugh Charles Edward et al**
**MEWBURN ELLIS & CO. 2/3 Cursitor Street**
**London EC4A 1BQ (GB)**

Courier Press, Leamington Spa, England.

## Description

This invention relates to a photoelectric device, which can be used for example in a solid state imager, a line sensor or a solar battery.

The conventional construction of the photoelectric conversion portion of a photoelectric device such as may be used in a solid-state imager or a line sensor, has a photoconductive layer which covers a metal electrode disposed on a body. A typical example of such a device occurs in a solid-state imager in which the photoconductive layer providing the imaging face covers the semiconductor body containing the switching elements, scanning circuitry etc. for processing signals from the photoelectric elements, which are arrayed in a matrix.

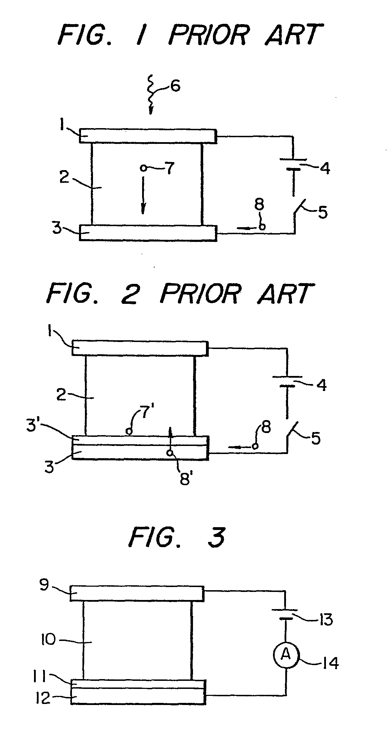

The principles of the construction of known photoelectric conversion portions is illustrated in Figures 1 and 2 of the accompanying drawings.

Figure 1 shows a transparent electrically conductive layer 1 on which light is incident a photoelectric conversion layer 2 basically comprising amorphous Se, a metal electrode 3 opposite the layer 1 on which light is incident, a voltage source 4 which drives the layer 2 and a switch 5 which represents a scanning circuit. Since the layer 2 is, in general, made from material of high-resistivity, the photoelectric conversion portions shown in Figure 1 can be regarded as a capacitive device.

By closing the switch 5 for an instant when light is not incident on the device, negative charges $-Q$ corresponding to the supply voltage 4 are induced on the metal electrode 3. After the switch 5 is subsequently opened, holes 7 generated in the layer 2 by thermal excitation or by incident light 6 travel towards the electrode 3, and positive charges $q$ ($q \ll Q$) are induced on the electrode 3. Ultimately, the charge on the electrode 3 amounts to $-Q+q$. When the switch 5 is then closed again, a negative charge 8 of $-q$ is supplied from the voltage source 4 towards the electrode 3 in order to restore the charge on the metal electrode 3 to $-Q$ corresponding to the supply voltage 4. This charge migration is then detected as a signal.

In the above process, and as shown in Figure 2, when an insulating surface oxide film 3' covers the metal electrode 3, the holes 7 generated in the layer 2 accumulate on the side of the oxide film 3' closer to the layer 2. Upon the subsequent closure of the switch 5, a high electric field is applied to the surface oxide film by the negative charge 8 supplied from the voltage source 4, and the negative charge 8 penetrates into the layer 2 as a result of the tunneling effect. The penetrating negative charges 8' cannot fill all the accumulated holes 7' with the result that the dark current of the device is increased and the photo-response accordingly deteriorates. Thus in the prior art, it has been thought necessary to use Au as the metal electrode, since Au has no surface layer.

Examples of the above described solid-state imagers are disclosed in Japanese Published Unexamined Patent Application No. 51-10715 (Hitachi).

The object of this invention is thus to reduce the dark current of such a device, when a surface insulating oxide film is present on the metal electrode.

The invention as claimed is intended to provide a solution.

The present invention makes it possible to use a metal electrode having an insulating oxide film on its surface, as if the surface oxide film were non-existent. The present invention can thus provide a photoelectric device the dark current of which is sufficiently suppressed and which thus exhibits a good photo-response.

In particular in the invention, a recombination layer for deliberately recombining electrons and holes is disposed between the metal electrode and the photoelectric conversion layer.

An inorganic material which has a forbidden band gap from 0.8 eV wide to 1.8 eV wide or so and which has a high localised state density in its forbidden band gap is preferably used as the recombination layer. Typical examples of materials of this sort are $Sb_2S_3$, $As_2Se_3$, $As_2S_3$, $As_2Te_3$, ZnSb, GaP, AlSb, $Sb_2Se_3$, $Pb_2S_3$, $Bi_2S_3$ and GaSe. The thickness of the layer is preferably at least 50 Å.

Embodiments of the present invention will now be described by way of example with reference to the accompanying drawings, in which:—

Figures 1 and 2 have already been described;

Figures 3, 6 and 8 are diagrams each showing a single picture element embodying the invention;

Figure 5 is a graph showing the relationship between the applied electric field and the dark current in a device as illustrated in Figure 3;

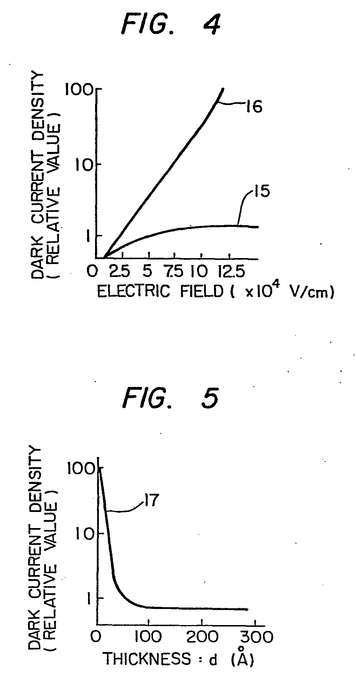

Figure 5 is a graph showing the relationship between the thickness of a recombination layer and the dark current in such a device;

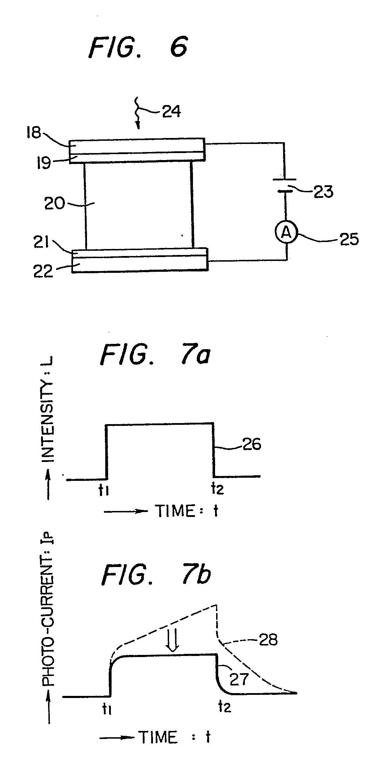

Figure 7a is a diagram showing a pulse shape of incident light, while Figure 7b is a diagram illustrating the photo-response thereto;

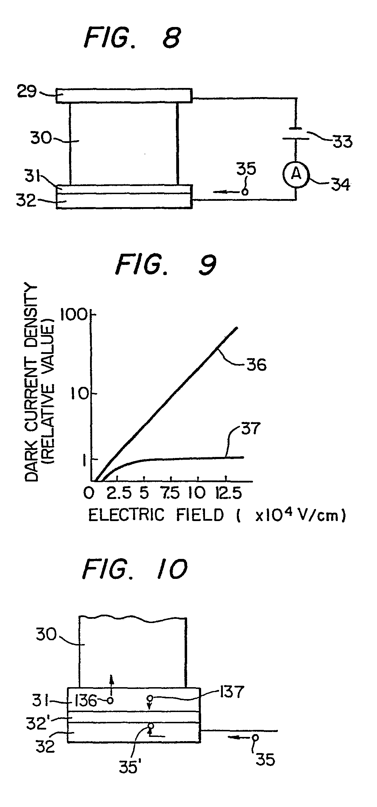

Figure 9 is a graph showing the relationship between the supply voltage and the dark current in certain devices;

Figure 10 is a diagram illustrating the principle of this invention;

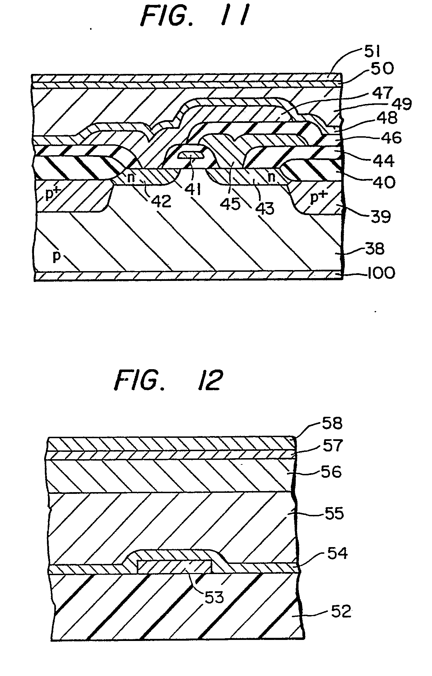

Figures 11 and 12 are sectional views of picture elements both embodying this invention;

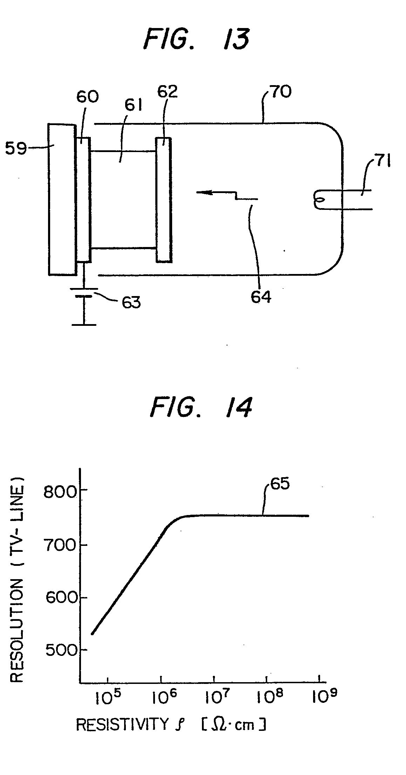

Figure 13 is a schematic explanatory diagram illustrating an apparatus for measuring the relationship between resistivity and resolution; and

Figure 14 is a graph showing the relationship between the resistivity of a recombination layer and the resolution.

In the device of Figure 3, a transparent conductive layer 9 has the function of blocking the injection of holes, and a photoelectric conversion layer 10 is made of a 10 $\mu$m thick layer of amorphous Se. There is a recombination layer 11, a metal electrode 12, a voltage source 13, and an ammeter 14. The recombination layer 11 is made of $As_2Se_3$, in this example.

The transparent conductive layer may be a layer which is only partly transparent, for example, a meshed metal film.

The layer 10 may be an amorphous or a crystalline material (e.g. a semiconductor). Typical examples of preferred amorphous materials are an Se-As-Te based material and amorphous Si containing hydrogen, and examples of preferred crystalline materials are CdSe, CdTe, PbS, etc.

Techniques for applying Se-As-Te based material and amorphous Si containing hydrogen to solid-state imagers are the subject of e.g. United States patent applications Serial Nos. 154,999 (1979) and 66,239 (1978).

The relationship between the applied electric field intensity E and the dark current $I_d$ as measured with the arrangement illustrated in Fig. 3 is illustrated in Figure 4. The dark current is indicated by relative values. The characteristic where the metal electrode 12 in Figure 3 has no surface oxide film should be as illustrated at 15, where the dark current is sufficiently suppressed.

If Al having a surface oxide film is used as the electrode 12 in Figure 3 and the recombination layer 11 is not inserted dark current is illustrated at 16 in Figure 4 and is not suppressed. If a recombination layer 11 of $As_2Se_3$ is inserted, dark current characteristic becomes again that shown at 15 in Figure 4.

Line 17 of Figure 5 illustrates the relationship between the thickness $d$ of the recombination layer and the dark current $I_d$ at the supply voltage which is optional for the device, and shows that the thickness $d$ at which the recombination layer attains its maximum effect is at least 50 Å. When this layer is too thick, the signal itself is reduced. Therefore, the recombination layer thickness is made, preferably, not greater than 5,000 Å and more preferably not greater than 3,000 Å. The thickness is determined in accordance with the resolution required. If this thickness is less than 50 Å, the number of levels in the forbidden band gap that can annihilate the electrons shown at 8′ in Figure 2 which have penetrated into the conversion layer 2 is insufficient, and the dark current characteristic is intermediate between the curves 15 and 16 of Figure 4.

Figure 6 shows an arrangement for assessing the photo-response of a photosensor. The device has a transparent Au electrode 18, a layer 19 for blocking the injection of holes from the Au electrode 18, a photoelectric conversion layer 20 made of amorphous Se-As-Te, a recombination layer 21 made of $Sb_2S_3$, a metal electrode 22, a voltage source 23. Incident light is shown at 24 and an ammeter at 25.

If the incident light 24 is pulsed as shown in Figure 7a, and if Cr having a surface oxide film is used as the metal electrode 22 and the recombination layer 21 is not inserted, a photoresponse in which the photo-current varies slowly with time as shown at 28 in Figure 7b is obtained. This is unusable for practical applications. However, if the recombination layer 21 of $Sb_2S_3$ and having a thickness of at least 50 Å is inserted, the photoresponse is that shown at 27 in Figure 7b, and consequently poses no problem in practical applications. The slow variation of the photo current with time as illustrated at 28 in Figure 7b is ascribable to the modulation of the dark current during the light projection.

As described above, with a recombination layer the metal electrode having a surface insulating oxide film can be used as if the surface oxide film were non-existent. In the foregoing examples, the recombination layer has been used in order to suppress the dark current of the photosensor, but it can also be used in order to achieve the effect of establishing an ohmic contact between the metal electrode having the surface oxide film and the photoelectric conversion layer. This will be described with reference to Figure 8.

The device of Figure 8 has a transparent Au electrode 29, a photoelectric conversion layer 30 of amorphous Se, a recombination layer 31 of $As_2S_3$ and a metal electrode 32. Also shown are a voltage source 33 and an ammeter 34. The polarity of the supply voltage in this example is opposite to that in Figures 1 to 6.

The dependence of the dark current $(I_d)$ upon the supply voltage (V) when the device is biassed in this manner is illustrated in Figure 9. If the metal electrode 32 is made of Al having a surface oxide film and there is no recombination layer 31 present, positive charges 35 which are supplied from the voltage source 33 through the electrode 32 to the conversion layer 30 are blocked by the surface oxide film, and the dark current is suppressed as shown by line 37 in Figure 9. In the present embodiment, however, when the recombination layer 31 made of $As_2S_3$ is present, the dark current density assumes an ohmic characteristic as shown at 36 in Figure 9.

The function of the recombination layer in this case will be described with reference to Figure 10. The structure of the photoelectric conversion portion 30 is the same as in Figure 8. The positive charge 35 is supplied from the voltage source to the electrode 32 are prevented from penetrating into the layer 30 by the surface oxide film 32′ of the electrode 32 and are stored as shown at 35′ in Figure 10. At the same time, holes 136 of electrons 137 generated in the recombination layer 31 by thermal excitation are injected into the layer 30,

while the electrons 137 are stored on the side of the surface oxide film 32' closer to the recombination layer. A high electric field is applied to the surface oxide film 32' by the electrons 137' and the stored holes 35' and the holes 35' or the electrons 137 pass through the surface oxide film, and are recombined. Thus, in effect, the characteristics of this embodiment are such as if the surface oxide film 32' were non-existent.

Further embodiments of the present invention will be described in detail below in the following examples.

Example 1

Figure 11 is a schematic sectional view of a solid state imager embodying the present invention. A MOS transistor was formed on a p-type silicon substrate 38. A $p^+$-type conductive region 39 and an oxide film 40 were formed for insulation purposes, and insulating oxide films 44 and 46 were also formed. Aluminum electrodes 47 and 45 were respectively formed on a source region 42 and a drain region 43. In order to fabricate a picture converter device, the electrodes are made in a very fine pattern in the shape of a comb or a matrix. A gate electrode 41 was formed of polycrystalline Si.

The structure thus far described is a semiconductor body portion which is usually called an "IC" or "LSI". Although only a single element is shown in the figure, actually many such elements are arranged in two dimensions to construct the whole circuit.

A recombination layer 48 made of $Sb_2S_3$ was formed on the aluminium electrode 47. The recombination layer 48 was deposited to a thickness in a range of 50 Å—1,500 Å using resistance heating in a vacuum of $1 \times 10^{-6}$ Torr. Subsequently, a photoelectric conversion layer 49 of amorphous Se-As-Te and whose principal photo-carriers were holes was deposited on the recombination layer 48 to a thickness in a range of 1—10 $\mu$. On the photoelectric conversion layer 49, $CeO_2$ was deposited to a thickness in the range of 50—300 Å as a hole blocking layer 50. A semitransparent layer 51 of Au which was 150 Å thick was then deposited on the layer 50 in order to block the injection of holes from the semi-transparent conductive layer. A second electrode 100 was deposited on the rear surface of the semiconductor substrate. With this structure, a solid-state imager which had a sufficiently suppressed dark current and a good photo-response was obtained.

The structure of the Se-Te-As based photoconductive layer of this device will now be described in more detail. The following layer parts are formed on the body.

The first part consists of a Se layer which contains at least one element which forms deep levels in Te or Se, the total quantity of such elements comprising at most about 10 atomic-%.

However, if the lifetime of the device is not a very important consideration, a Se layer without any such additional elements may be used.

The elements considered to form deep levels in Se are group-Vb elements such as As, Sb and Bi and group-IV elements such as Si and Ge and any one or more of them or one or more compounds each containing at least one of them may be used. These elements may coexist with Te, or be present without Te. With such elements forming deep levels, particularly when the device is operated continuously for a long time changes in the signal current are extraordinarily small, and the after-image is remarkably reduced.

This first part is preferably made 0.5—10 $\mu$m thick, and it is principally used to cause holes generated in the third part to migrate so as to reduce the capacitance of the photoconductor and also to eliminate pinholes etc. The thickness of this film should more preferably be 1—4 $\mu$m.

The second part is a part into which a dopant (in this case As) to form deep levels is introduced in order to enhance the effect of intensifying the sensitivity to red light due to Te contained in the third part and also to suppress signal current changes when the device is operating for long periods of time. In order to achieve these functions effectively, the second part should be a Se layer in which the concentration of the dopant forming deep levels is at least 15 atomic-% at the peak of a continuous concentration distribution. In practice, concentrations of at most 40 atomic-% are often employed. It is preferable that the concentration distribution of this dopant is such that the concentration is highest at the interface of the second part which lies in contact with the third part and decreases smoothly over 200—3,000 Å from the interface. This layer is usually 100 Å—5,000 Å thick.

In order to attain a satisfactory sensitivity in the visible region, the third part should be an Se layer in which the peak concentration of the continuous distribution of Te concentrations is at least 15 atomic-%, and particularly preferably falls in a range of 15—30 atomic-%. It is also desirable that the thickness of this part is 200—5,000 Å. The distribution of the Te concentrations in the third part is uniform and is rectangular, but the shape of the distribution is not restricted to rectangular. A distribution which is triangular, trapezoidal or semicircular or a more complicated shape may also be used. The fourth part is a part which must lie in contact with the n-type transparent conductive film, to be disposed on the photoconductor layer, so as to form a rectifying contact. The Te concentration of this Se layer part must not exceed 15 atomic-% on average in order to establish a stable rectifying contact, and an element such as As and Ge with which this part is doped in order to increase the thermal stability must not exceed a concentration of 15 atomic-% on average, either. The thickness of this part needs to be at least 100 Å. If the lifetime is not a very important consideration, a Se layer may be used which has no additional elements present.

However, when the fourth part is made thicker than is necessary, the quantity of light entering the third part decreases thus lowering the sensitivity, so that a thickness of at most 1,000 Å is preferable in practice.

The concentrations of Te, As, Ge, etc. may be controlled by considering the concentration distributions thereof as continuous macroscopic concentration distributions.

In the photoconductive film in the present example, a film which has a macroscopically continuous distribution and which exhibits a desired composition ratio or composition distribution can be produced by employing Se and $As_2Se_3$ or Te and Ge or the like as a vapour source. By using a rotating type evaporation apparatus, several thousand layers, each layer being several angstroms to several tens of angstroms thick, can be cyclically deposited on the body.

In this case, the composition ratio of the continuous distribution is defined to be the continuous distribution of an average composition ratio within a composite layer which is constructed of the sum of the respectively layers of one sort or two or more sorts of vapours evaporated cyclically, that is, a composite layer which is formed by one cycle of the rotary evaporation.

Example 2

The fundamental structure of this example is the same as in Figure 11, and will therefore be described with reference thereto. A scanning circuit portion including a switching circuit etc. to be formed in a semiconductor body was fabricated by the use of conventional manufacturing steps for semiconductor devices. A thin $SiO_2$ film of approximately 800 Å was formed on a p-type silicon substrate 38, and an $Si_3N_4$ film of approximately 1,400 Å was formed at a predetermined position on the $SiO_2$ film. The formation of the $SiO_2$ film was by the ordinary CVD process, while that of the $SiN_4$ film was by a CVD process in which $Si_3N_4$, $NH_4$ and $N_2$ were caused to flow. p-type diffused regions 39 were formed by ion implantation which was carried out from above the silicon substrate. The diffused regions 39 were disposed in order to improve the insulation of the respective elements. The silicon was subsequently oxidized locally in an atmosphere of $H_2:O_2=1:8$, to form an $SiO_2$ layer 40. this method is a process for the local oxidation of silicon for insulating elements and is usually called "LOCOS". The $Si_3N_4$ film and the $SiO_2$ film stated above were once removed, and a gate insulating film for a MOS transistor was formed from an $SiO_2$ film.

Subsequently, a gate portion 41 made of polycrystalline silicon and diffused regions 42 and 43 were formed, and an $SiO_2$ film 44 was formed thereon. Electrode lead-out openings for the source 42 and the drain 43 were provided in the film by etching. An Al layer 8000 Å thick was deposited as a drain electrode 45. An $SiO_2$ film 46 was formed which was 7500 Å thick and Al 1 $\mu$m thick was subsequently deposited as a source electrode 47. The electrode 47 was formed so as to cover the regions 42 and 43 and the gate portion 41. This is because the incidence of light on a signal processing region extending between the diffused layers 39 for insulating the elements causes blooming and is undesirable.

At the next step, on at least the aluminum electrodes a 100 Å thick recombination layer 48 made of $Sb_2S_3$ was formed. The process for the formation was the same as stated before.

Subsequently, the semiconductor body prepared by the steps thus far described was installed in a magnetron type sputtering apparatus. The atmosphere used was a gaseous mixture consisting of Ar and hydrogen, and was kept at a pressure of 0.2 Torr. The hydrogen content was 6 mol-%. The sputter target used was made of silicon. By carrying out a reactive sputtering at a frequency of 13.56 MHz and an input power of 300 W, a thin film 49 of amorphous silicon containing hydrogen was deposited on the semiconductor body to a thickness of 500 nm. The hydrogen content of the amorphous thin film was 20 atomic-%, and the resistivity thereof was $5 \times 10^{13}$ $\Omega \cdot$ cm.

The photoconductive thin film is of an amorphous material whose principal constituent is silicon containing hydrogen. More preferably this material is an amorphous material which contains at least 50 atomic-% of silicon and 5 atomic-% to 50 atomic-% of hydrogen. In this case, part of the silicon in the amorphous material can be substituted by germanium which is an element of the same periodic group. Up to 60% of the silicon may be usefully substituted thus.

The thickness of the film is preferably 0.2 $\mu$m—4 $\mu$m in practice. The thin film may be in a multilayer form or have its composition varied continuously as well.

A first electrode for a bias voltage needs to be disposed on the amorphous silicon thin film 49. Since, in this example, light is required to enter from above, the electrode was made transparent. As the heat resistance of the amorphous silicon was 300°C, a transparent electrode made of $In_2O_3$ was used. The transparent electrode of $In_2O_3$ itself plays the role of a hole blocking layer 50. In this case, the hole blocking layer 50 shown in Figure 11 is unnecessary. Using a mask, Cr-Au was deposited onto that part of the transparent electrode which was not a light receiving part, and a wire was bonded thereto, to connect up the biasing electrode. In addition, a second electrode 100 was formed of an Au film or the like on the rear surface of the semiconductor body. In this way, the solid-state imager was completed.

With this structure, the dark current was suppressed sufficiently.

Example 3

In a device as described in Example 1, for the recombination layer indicated at 48 in Figure 11 a GaSe layer was deposited to a thickness in the range 50 Å—3,000 Å using electron-beam evaporation in a vacuum of $2 \times 10^{-5}$ Torr. On the recombination layer 48, a layer of amorphous Si 2 $\mu$m thick and containing 20% of hydrogen was formed as a photoelectric conversion layer 49 by radio-frequency sputtering at a substrate temperature of 250°C. Subsequently a 60 Å thick layer of Pt was deposited as a transparent conductive layer 51 using electron beam evaporation in a vacuum of $1 \times 10^{-6}$ Torr. In this case, the major photo-carriers in the photoelectric conversion layer were electrons. An electron injection blocking layer corresponding to the hole injection blocking layer in Example 1 was unnecessary. With the device having this structure, a solid-state imager having good imaging characteristics was obtained.

A similar effect can be achieved even when the material forming the recombination layer is at least one of $As_2S_3$, $Sb_2Se_3$, $As_2Te_3$, ZnSb, GaP, $Pb_2S_3$, AlSb and $Bi_2S_3$. A combination of two or more of these materials can be used for the recombination layer, e.g. a mixture consisting of $Sb_2S_3$ and $As_2Se_3$ or a mixture consisting of $Sb_2S_3$ and $As_2S_3$.

Example 4

Figure 12 is a schematic sectional view of a line sensor which is yet another embodiment of this invention.

On a surface-polished plastic substrate 52 which was worked so as to be opaque, a Cr electrode 53 was deposited using resistance heating evaporation in a vacuum of $1 \times 10^{-5}$ Torr. Subsequently, $As_2Se_3$ was formed as a recombination layer 54 to a thickness in the range 50 Å—5,000 Å using resistance heating in a vacuum of $5 \times 10^{-6}$ Torr. On the recombination layer, a first photoelectric conversion layer 55 made of amorphous Se-As and having a thickness of 5 $\mu$m and a second photoelectric conversion layer 56 made of amorphous Se-As-Te and having a thickness of 0.08 $\mu$m were successively deposited in a vacuum of $1 \times 10^{-6}$ Torr. Subsequently, a film having a thickness of 200 Å and made of $In_2O_3$ and $SnO_2$ was formed at a substrate temperature of 40°C by the magnetron sputtering process to act as a transparent conductive layer 57 which also serves the function of blocking the injection of holes. In the next step, a surface protective layer 58, consisting of a layer of $SiO_2$ 2,000 Å thick was formed at a substrate temperature of 50°C by the intermittent sputtering process. Although only a single element is shown in the figure, such elements are linearly arrayed so as to form a linear sensor.

If, as in Examples 1—3, the recombination layer of this invention is used on the metal electrode having the surface oxide film divided into a very fine pattern, it needs to have a resistance greater than a certain value in order to prevent the transverse flow of carriers. The resistance required of the recombination layer was determined by employing the structure of the target of a conventional vidicon type image pickup tube as shown in Figure 13. The use of the image pickup tube for determining the resistance of the recombination layer involves no difficulty. This method was adopted because of the easy measurement possible.

Figure 13 shows a glass substrate 59, a transparent conductive layer 60 which also has the function of blocking the injection of holes, a photoelectric conversion layer 61 which is 6 $\mu$m thick and which is made of amorphous Se, a recombination layer 62 which is 500 Å thick, a voltage source 63, and a scanning electron beam 64. There is an envelope 70, and an electron gun 71. The construction of the parts including structural parts not shown but other than the target, is as in the conventional image pickup tube. The relationship between the resistivity and the resolution of a picture was evaluated by imaging respective resolution patterns in cases where the resistivity $\rho$ was varied by changing the material forming the recombination layer 62. The result is illustrated by the curve 65 in Figure 14. To scan the recombination layer with the electron beam in this manner is equivalent to splitting the metal electrode into the very fine pattern. As is apparent from the curve 65 in Figure 14, the material of the recombination layer needs to have a resistivity of at least $10^6$ $\Omega \cdot$ cm. Of course, the resistivity of the material of the recombination layer needs to be lower than that of the photoelectric conversion material, and hence, values of $10^{12}$—$10^{13}$ $\Omega \cdot$ cm will be the upper limit in practice.

To summarise, in this invention, a metal electrode having a surface oxide film can be used as if the surface oxide film were non-existent. The present invention is accordingly applicable to improvements of the characteristics of electrical contact with electrodes in not only the solid-state imagers, line sensors etc. mentioned above, but also in various other photoelectric devices such as solar batteries.

**Claims**

1. A photoelectric device comprising a metal electrode (12) having a surface oxide film, at least one layer of photoelectric conversion material (10) covering at least a part of said metal electrode (12), an at least partially transparent layer of conductive material (9) and a layer (19) of material capable of blocking the injection of photocarriers of the same type as the major photocarriers in the photoelectric conversion material into the layer of photoelectric conversion material, both the photocarrier blocking layer (19) and the transparent conductive layer (9) (which are optionally the same layer) covering at least a part of said photoelectric conversion material (10), characterized in that a recombination layer (11) of material capable of recombining holes and electrons is disposed between said metal electrode (12) and said layer (10) of photoelectric conversion material.

2. A device according to claim 1, wherein said recombination layer (11) comprises an inorganic material whose forbidden band gap is from 0.8 eV wide to 1.8 eV wide and which has a high localised state density in said forbidden band gap.

3. A device according to claim 1 or claim 2 wherein said recombination layer (11) is formed of at least one of $Sb_2S_3$, $As_2Se_3$, $As_2S_3$, $Sb_2Se_3$, $As_2Te_3$, ZnSb, GaP, $Pb_2S_3$, AlSb, $Bi_2S_3$ and GaSe.

4. A device according to any one of claims 1 to 3 wherein the thickness of said recombination layer (11) is from 50 Å to 5,000 Å.

5. A device according to any one of claims 1 to 4 wherein said recombination layer (11) has a resistivity of at least $10^6 \ \Omega \cdot cm$.

6. An electronic device having a plurality of photoelectric devices according to any one of claims 1 to 5, arrayed on a semiconductor substrate which includes scanning means for sequentially selecting said photoelectric devices, there being for each photoelectric device a metal electrode (47) disposed on said semiconductor substrate and functioning as the said metal electrode of the photoelectric devices.

**Patentansprüche**

1. Photoelektrische Vorrichtung mit einer Metallelektrode (12) mit einem Oberflächen-Oxidfilm, zumindest einer Schicht aus einem photoelektrischen Konversionsmaterial (10), die zumindest einen Teil der Metallelektrode (12) bedeckt, und einer zumindest teilweise transparenten Schicht aus leitfähigem Material (9) sowie einer Schicht (19) aus einem Material, das geeignet ist, die Injektion von Phototrägern desselben Typs wie die Majoritäts-Phototräger im photoelektrischen Konversionsmaterial in die Schicht aus dem photoelektrischen Konversionsmaterial zu blockieren, wobei sowohl die Phototräger-Blockierschicht (19) als auch die transparente leitfähige Schicht (9) (die nach Wahl dieselbe Schicht sind) zumindest einen Teil des genannten photoelektrischen Konversionsmaterials (10) bedecken, dadurch gekennzeichnet, daß eine Rekombinationsschicht (11) aus einem für die Rekombination von Löchern und Elektronen geeigneten Material zwischen der Metallelektrode (12) und der Schicht (10) aus photoelektrischem Konversionsmaterial angeordnet ist.

2. Vorrichtung nach Anspruch 1, wobei die Rekombinationsschicht (11) ein anorganisches Material aufweist, dessen verbotene Bandlücke von 0,8 eV bis 1,8 eV breit ist und das in dieser verbotenen Bandlücke eine hohe lokalisierte Zustandsdichte aufweist.

3. Vorrichtung nach Anspruch 1 oder Anspruch 2, wobei die genannte Rekombinationsschicht (11) zumindest aus einer der Verbindungen $Sb_2S_3$, $As_2Se_3$, $As_2S_3$, $Sb_2Se_3$, $As_2Te_3$, ZnSb, GaP, $Pb_2S_3$, AlSb, $Bi_2S_3$ und GaSe gebildet ist.

4. Vorrichtung nach einem der Ansprüche 1 bis 3, wobei die Dicke der Rekombinationsschicht (11) zwischen 50 Å und 5000 Å liegt.

5. Vorrichtung nach einem der Ansprüche 1 bis 4, wobei die Rekombinationsschicht (11) einen spezifischen Widerstand von zumindest $10^6 \ \Omega \cdot cm$ aufweist.

6. Elektronisches Gerät mit einer Vielzahl von photoelektrischen Vorrichtungen nach einem der Ansprüche 1 bis 5, die auf einem Halbleitersubstrat angeordnet sind, das eine Abtasteinrichtung für die sequentielle Auswahl der photoelektrischen Vorrichtungen aufweist, wobei für jede photoelektrische Vorrichtung eine Metallelektrode (47) vorgesehen ist, die auf dem Halbleitersubstrat angeordnet ist und als die genannte Metallelektrode der photoelektrischen Vorrichtungen funktioniert.

**Revendications**

1. Dispositif photoélectrique comportant une électrode métallique (12) possédant une pellicule d'oxyde superficielle, au moins une couche d'un matériau de conversion photoélectrique (10) recouvrant au moins une partie de ladite électrode métallique (12), une couche au moins partiellement transparente d'un matériau conducteur (9) et une couche (19) d'un matériau pouvant arrêter l'injection de porteurs photoélectriques du même type que les porteurs photoélectriques majoritaires situés dans le matériau de conversion photoélectrique, dans la couche de conversion photoélectrique, à la fois la couche (19) d'arrêt des porteurs photoélectriques et la couche conductrice (9) (qui constitute optionnellement la même couche) recouvrant au moins une partie dudit matériau de conversion photoélectrique (10), caractérisé en ce qu'une couche de recombinaison (11) constituée en un matériau apte à recombiner les trous et les électrons est disposée entre ladite électrode métallique (12) et ladite couche (10) du matériau de conversion photoélectrique.

2. Dispositif selon la revendication 1, dans lequel ladite couche de recombinaison (11) est constituée par un matériau inorganique dont la bande interdite possède une largeur comprise entre 0,8 eV et 1,8 eV et qui possède une densité élevée d'états localisés dans ladite bande interdite.

**0 029 679**

3. Dispositif selon la revendication 1, ou 2, dans lequel ladite couche de recombinaison (11) est constituée par au moins l'un des éléments: $Sb_2S_3$, $As_2Se_3$, $As_2S_3$, $Sb_2Se_3$, $As_2Te_3$, ZnSb, GaP, $Pb_2S_3$, AlSb, $Bi_2S_3$ et GaSe.

4. Dispositif selon l'une quelconque des revendications 1 à 3, dans lequel l'épaisseur de ladite couche de recombinaison (11) est comprise entre 50 Å et 5000 Å.

5. Dispositif selon l'une quelconque des revendications 1 à 4, dans lequel ladite couche de recombinaison (11) possède une résistivité égale à au moins $10^6$ $\Omega \cdot$ cm.

6. Dispositif électronique possédant une pluralité de dispositifs photoélectriques selon l'une quelconque des revendications 1 à 5, disposés en réseau sur un substrat semiconducteur qui comporte des moyens de balayage permettant de sélectionner de façon séquentielle lesdits dispositifs photoélectriques, avec pour chaque dispositif photoélectrique une électrode métallique (47) disposée sur ledit substrat semiconducteur et agissant de manière à constituer ladite électrode métallique des dispositifs photoélectriques.

FIG. 1 PRIOR ART

FIG. 2 PRIOR ART

FIG. 3

## FIG. 4

## FIG. 5

# FIG. 6

# FIG. 7a

# FIG. 7b

# FIG. 8

# FIG. 9

DARK CURRENT DENSITY (RELATIVE VALUE)

ELECTRIC FIELD ( x10⁴ V/cm)

# FIG. 10

*FIG. 11*

*FIG. 12*

## FIG. 13

## FIG. 14